# EUROPEAN PATENT APPLICATION

(11) **EP 4 819 137 A1**
(43) Date of publication of application: **07.10.2026**
(21) Application number: 26165356.2
(22) Date of filing: 17.03.2026
(51) Int. Cl.: G11C 7/12, G11C 11/4091

(54) **MEMORY DEVICE AND METHOD OF OPERATION THEREOF**

(30) Priority: 04.04.2025 KR 20250044048
(71) Applicant: Samsung Electronics Co., Ltd., Suwon-si, Gyeonggi-do 16677 (KR)
(72) Inventor: LEE, Changyoung, 16677 Suwon-si, Gyeonggi-do (KR); PARK, Young Seok, 16677 Suwon-si, Gyeonggi-do (KR); YOO, Changsik, 16677 Suwon-si, Gyeonggi-do (KR); SEO, Younghun, 16677 Suwon-si, Gyeonggi-do (KR); KANG, Kyu-Chang, 16677 Suwon-si, Gyeonggi-do (KR)
(74) Representative: Kuhnen & Wacker Patent- und Rechtsanwaltsbüro PartG mbB

(57) **Abstract**

Provided is a memory device including a first sense amplification circuit (42) connected to a first input and output line pair (LIO, LIOB), a pre-charge circuit (44) connected to a second input and output line pair (GIO, GIOB), and a first switch circuit (43), wherein the pre-charge circuit (44) is configured to pre-charge the second input and output line pair (GIO, GIOB) at a pre-charge voltage after the first switch circuit (43) disconnects the first input and output line pair (LIO, LIOB) from the second input and output line pair (GIO, GIOB), and wherein the first switch circuit (43) is configured to connect the first input and output line pair (LIO, LIOB) and the second input and output line pair (GIO, GIOB) to deliver a voltage of the first input and output line pair (LIO, LIOB), which is amplified by the first sense amplification circuit (42), to the pre-charged second input and output line pair (GIO, GIOB) in a read operation.

## Description

### FIELD

Example embodiments relate to a memory device, and more specifically, to a memory device and an operation method thereof.

### BACKGROUND

A memory device may be used to store data in various applications, and may update or output the stored data according to a received command. For instance, a memory device may store data in response to a write command, and output the stored data in response to a read command. A memory device may consume power while performing a write operation and a read operation, and, in case that the write operation and the read operation are frequently performed, power consumption of the memory device may be increased. In particular, in a case of applications such as a mobile device consuming power of a battery or a system including a vast memory device, power consumption of a memory device may be critical.

### SUMMARY

Aspects provide a memory device which consumes reduced power and an operation method thereof.

According to aspects, there is provided a memory device including a first sense amplification circuit connected to a first input and output line pair, a pre-charge circuit connected to a second input and output line pair, and a first switch circuit between the first input and output line pair and the second input and output line pair, wherein the pre-charge circuit is configured to pre-charge the second input and output line pair at a pre-charge voltage after the first switch circuit disconnects the first input and output line pair from the second input and output line pair, and wherein the first switch circuit is configured to connect the first input and output line pair and the second input and output line pair to deliver a voltage of the first input and output line pair, which is amplified by the first sense amplification circuit, to the pre-charged second input and output line pair in a read operation.

According to aspects, there is provided an operation method of a memory device, including, disconnecting, in a read operation, a first input and output line pair and a second input and output line pair, pre-charging, in the read operation, the second input and output line pair at a pre-charge voltage, amplifying, in the read operation, a voltage of the first input and output line pair, and connecting, in the read operation, in order for the amplified voltage of the first input and output line pair to be delivered to the pre-charged second input and output line pair, the first input and output line pair and the second input and output line pair.

According to aspects, there is provided a memory device including a first input and output line pair, a sense amplification circuit configured to amplify a voltage of the first input and output line pair to output the same to the first input and output line pair, a second input and output line pair, a pre-charge circuit configured to pre-charge the second input and output line pair at a pre-charge voltage, and a first switch circuit connecting or disconnecting the first input and output line pair and the second input and output line pair according to a first control signal.

### BRIEF DESCRIPTION OF THE FIGURES

These and/or other aspects, features, and advantages of the invention will become apparent and more readily appreciated from the following description of example embodiments, taken in conjunction with the accompanying drawings of which:
FIG. 1 is a block diagram illustrating a system according to example embodiments of the present disclosure;
FIG. 2 is a block diagram illustrating a memory device according to example embodiments of the present disclosure;
FIG. 3 is a block diagram illustrating a memory device according to example embodiments of the present disclosure;
FIG. 4 is a circuit diagram illustrating a memory device according to example embodiments of the present disclosure;
FIG. 5 is a timing chart illustrating an operation of a memory device according to example embodiments of the present disclosure;
FIG. 6A and FIG. 6B are circuit diagrams illustrating examples of a write driver according to example embodiments of the present disclosure;
FIG. 7 is a timing chart illustrating an operation of a memory device according to example embodiments of the present disclosure;
FIG. 8A and FIG. 8B are timing charts illustrating examples of an operation of a memory device according to example embodiments of the present disclosure;
FIG. 9 is a circuit diagram illustrating a memory device according to example embodiments of the present disclosure;
FIG. 10 is a block diagram illustrating a memory device according to example embodiments of the present disclosure;
FIG. 11 is a flowchart illustrating an operation method of a memory device according to example embodiments of the present disclosure;
FIG. 12 is a flowchart illustrating an operation method of a memory device according to example embodiments of the present disclosure;
FIG. 13 is a drawing illustrating a layout of an integrated circuit device according to example embodiments of the present disclosure;
FIG. 14 is a perspective view illustrating an integrated circuit device according to example embodiments of the present disclosure; and
FIG. 15 is a cross-sectional view cutting an integrated circuit device along an X1-X1' line and a Y1-Y1' line of FIG. 13 according to example embodiments of the present disclosure.

### DETAILED DESCRIPTION

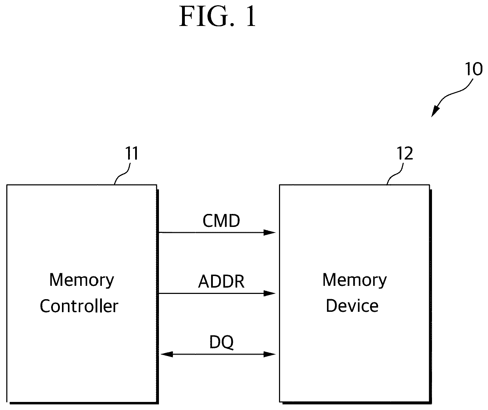

FIG. 1 is a block diagram illustrating a system 10 according to example embodiments of the present disclosure. As illustrated in FIG. 1, the system 10 may include a memory controller 11 and a memory device 12, and may be referred to as a memory system. In some example embodiments, the memory controller 11 and the memory device 12 may be manufactured by a semiconductor process, and may be included in a single package or respectively included in two packages.

The memory controller 11 may communicate with a host and the memory device 12, and may control data exchange between the host and the memory device 12. As an example, the memory controller 11 may write data into the memory device 12, or read the data stored in the memory device 12 according to a request received by the host. As illustrated in FIG. 1, the memory controller 11 may provide a command CMD, an address ADDR and data DQ to the memory device 12, and may receive the data DQ from the memory device 12.

The memory device 12 may receive the command CMD, the address ADDR and the data DQ from the memory controller 11, and may provide the data DQ to the memory controller 11. The memory device 12 may include memory cells, and each of the memory cells may store at least one bit.

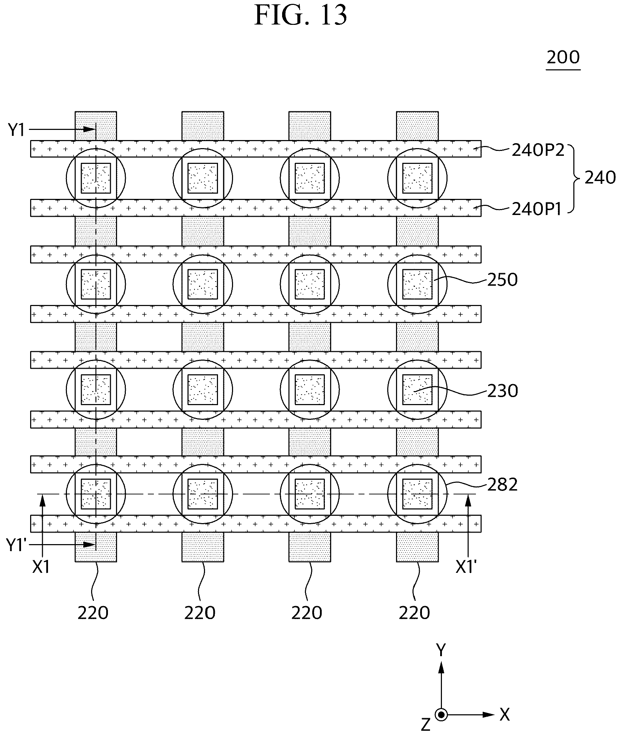

In some example embodiments, the memory device 12 may include volatile memory cells. For example, the memory device 12 may be dynamic random access memory (DRAM) devices such as a double data rate (DDR) synchronous dynamic random access memory (SDRAM), a DDR2 SDRAM, a DDR3 SDRAM, a DDR4 SDRAM, a DDR5 SDRAM, a DDR6 SDRAM, a low power double data rate (LPDDR) SDRAM, an LPDDR2 SDRAM, an LPDDR3 SDRAM, an LPDDR4 SDRAM, an LPDDR4X SDRAM, an LPDDR5 SDRAM, a graphics double data rate (GDDR) synchronous graphics random access memory (SGRAM), a GDDR2 SGRAM, a GDDR3 SGRAM, a GDDR4 SGRAM, a GDDR5 SGRAM, a GDDR6 SGRAM and the like. In some example embodiments, DRAM dies may be stacked in the memory device 12 such as a high bandwidth memory (HBM), an HBM2, an HBM3 and the like. In some example embodiments, the memory device 12 may be a memory module such as a single in-line memory module (SIMM), a dual in-line memory module (DIMM) and the like. For example, the memory device 12 may be a registered DIMM (RDIMM), a load-reduced DIMM (LRDIMM), an unbuffered DIMM (UDIMM), a fully-buffered DIMM (FB-DIMM) and a small-outline DIMM (SO-DIMM). In some example embodiments, the memory device 12 may include a vertical channel transistor (VCT) as described hereinafter with reference to FIG. 13 and the like.

In some example embodiments, the memory device 12 is a non-volatile memory device and may include non-volatile memory cells. For example, the memory device 12 may be a non-volatile memory device such as a NAND flash memory, a NOR flash memory, a resistive random access memory (RRAM) and the like. Hereinafter, a DRAM device will be mainly described as a volatile memory device, but it should be noted that example embodiments of the present disclosure are not limited thereto.

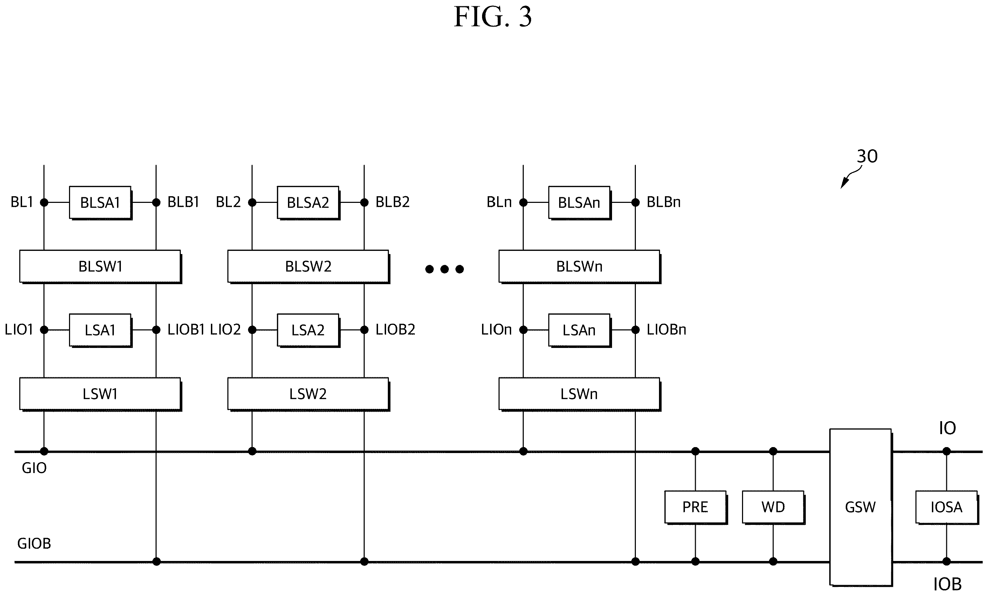

The memory device 12 may include a circuit to read data (may be referred to as read data herein) stored in a memory cell or to write data (may be referred to as written data herein) in a memory cell. For example, as described hereinafter with reference to FIG. 3 and the like, the memory device 12 may include a sense amplifier, and the sense amplifier may be used to read data from a memory cell or write data into a memory cell. Due to advancement of a semiconductor process and the like, the number of memory cells included in the memory device 12 may be increased, and a size of a cell array including memory cells may be increased. Accordingly, a circuit for reading or writing data may be hierarchically configured. For example, a memory cell may be accessed by not only a bit line pair but also additional input and output line pairs. An input and output line pair may be connected to another input and output line pair by a switch circuit, and may be connected to a sense amplifier and/or a pre-charger.

In case that the memory device 12 performs a write operation and a read operation according to the command CMD provided by the memory controller 11, power may be consumed, and, the more frequent the write operation and the read operation are, the greater the power consumption may be. As described hereinafter with reference to the drawings, in the memory device 12, a swing voltage of an input and output line pair with a high parasitic capacitance may be reduced, and a charge may be re-used to pre-charge an input and output line pair. Further, according to a location of a memory cell in a cell array of the memory device 12, timing of a control signal may be adjusted, and unnecessary pre-charge of an input and output line pair may be omitted. Accordingly, the memory device 12 may consume reduced power, and, as a result, power consumption of the system 10 may be reduced.

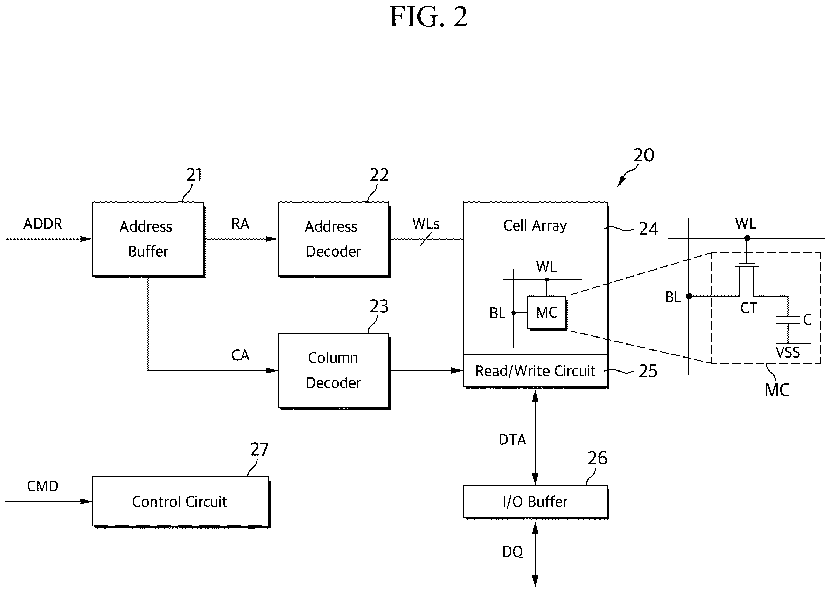

FIG. 2 is a block diagram illustrating a memory device 20 according to example embodiments of the present disclosure. The memory device 20 of FIG. 2 may be an example of the memory device 12 of FIG. 1, but it should be noted that the memory device 12 of FIG. 1 is not limited to the memory device 20 of FIG. 2. As illustrated in FIG. 2, the memory device 20 may include an address buffer 21, a row decoder 22, a column decoder 23, a cell array 24, a read/write circuit 25, an input and output buffer (I/O buffer) 26 and a control circuit 27.

The address buffer 21 may receive the address ADDR, and may extract a row address RA and a column address CA from the address ADDR. As illustrated in FIG. 2, the address buffer 21 may provide the row address RA to the row decoder 22, and may provide the column address CA to the column decoder 23.

The row decoder 22 may be connected to the cell array 24 through a plurality of word lines WLs. The row decoder 22 may select one among the plurality of word lines WLs based on the row address RA, and may activate a selected word line. For example, the row decoder 22 may apply a word line driving voltage to a selected word line. The column decoder 23 may be connected to the read/write circuit 25. In some example embodiments, the column decoder 23 may enable a sub-circuit (for example, a sense amplifier) included in the read/write circuit 25 based on the column address CA.

The cell array 24 may include a plurality of memory cells. As illustrated in FIG. 2, a memory cell MC may be connected to a word line WL and a bit line BL. As a DRAM cell, the memory cell MC may include a cell transistor CT and a capacitor C. In some example embodiments, the cell transistor CT may be a field effect transistor (FET). The cell transistor CT may be connected between the bit line BL and the capacitor C, and may have a gate connected to the word line WL. The capacitor C may have one end connected to the cell transistor CT, and may have another end to which a constant potential, for instance, a negative supply voltage VSS, is applied. The cell transistor CT may connect the capacitor C to the bit line BL in response to the activated word line WL. By the cell transistor CT, a charge stored in the capacitor C may be delivered to the bit line BL in a read operation, while a charge of the bit line BL may be delivered to the capacitor C in a write operation.

The read/write circuit 25 may write data into at least one memory cell included in the cell array 24, or read data from at least one memory cell. For example, in a read operation, the read/write circuit 25 may output a data signal DTA by sensing a signal received from the memory cell MC by the bit line BL, for instance, a voltage and/or a current. Further, in a write operation, the read/write circuit 25 may apply a signal to the bit line BL based on the data signal DTA to write data into the memory cell MC. In some example embodiments, the read/write circuit 25 may include sense amplifiers, and the sense amplifiers selected by the column decoder 23 may be enabled in a read operation and a write operation. Examples of the read/write circuit 25 will be described hereinafter with reference to the drawings.

The input and output buffer 26 may be connected to the read/write circuit 25. The input and output buffer 26 may, in a read operation, store values corresponding to the data signal DTA received from the read/write circuit 25, and may output the data DQ corresponding to at least a portion of the stored values according to control of the control circuit 27. Further, the input and output buffer 26 may, in a write operation, store values corresponding to the received data DQ, and may provide the data signal DTA corresponding to at least a portion of the stored values to the read/write circuit 25 according to control of the control circuit 27. In some example embodiments, the memory device 20 may further include an error correction code (ECC) engine between the read/write circuit 25 and the input and output buffer 26, and memory cells included in the cell array 24 may store a codeword generated by the ECC engine.

The control circuit 27 may receive the command CMD, and may control an operation of the memory device 20. For example, the control circuit 27 may generate a control signal for a read operation, a write operation and a refresh operation. In some example embodiments, the control circuit 27 may include a command decoder for decoding the command CMD, and may generate control signals according to the decoded command. For example, the control circuit 27 may identify a read operation or a write operation according to the decoded command, and may generate control signals according to an identified operation. In some example embodiments, the control circuit 27 may include a mode register, and may store a value in the mode register based on the command CMD, the address ADDR and/or the data DQ. The control circuit 27 may identify one among a plurality of modes according to a value stored in the mode register, and may generate control signals according to an identified mode.

FIG. 3 is a block diagram illustrating a memory device 30 according to example embodiments of the present disclosure. For example, the block diagram of FIG. 3 illustrates an example of a read/write circuit included in the memory device 30. Referring to FIG. 3, the memory device 30 may include a first bit line sense amplifier BLSA1 to an nth bit line sense amplifier BLSAn, a first bit line switch BLSW1 to an nth bit line switch BLSWn, a first local sense amplifier LSA1 to an nth local sense amplifier LSAn, a first local switch LSW1 to an nth local switch LSWn, a pre-charger PRE, a write driver WD, a global switch GSW and an input and output sense amplifier IOSA (n is an integer greater than 1). Further, the memory device 30 may include a first bit line BL1 to an nth bit line BLn, a first complementary bit line BLB1 to an nth complementary bit line BLBn, a first local input and output line LIO1 to an nth local input and output line LIOn, a first complementary local input and output line LIOB1 to an nth complementary local input and output line LIOBn, a global input and output line GIO, a complementary global input and output line GIOB, an input and output line IO and a complementary input and output line IOB.

Herein, a local input and output line pair including a local input and output line and a complementary local input and output line may be referred to as a first input and output line pair, and a global input and output line pair including the global input and output line GIO and the complementary global input and output line GIOB may be referred to as a second input and output line pair, and an input and output line pair including the input and output line IO and the complementary input and output line IOB may be referred to as a third input and output line pair. Herein, a bit line switch, a local switch and a global switch may be respectively referred to as a first switch circuit, a second switch circuit and a third switch circuit. Further, a local sense amplifier and the input and output sense amplifier IOSA may be referred to as a first sense amplification circuit and a second sense amplification circuit. Further, herein, two components being connected or disconnected may signify being electrically connected or disconnected unless otherwise described.

The first bit line sense amplifier BLSA1 may be connected to a first bit line pair, and, when being enabled, may amplify a voltage of the first bit line pair. The first bit line switch BLSW1 may connect a first bit line pair and a first local input and output line pair according to a control signal between the first bit line pair and the first local input and output line pair. The first local sense amplifier LSA1 may be connected to a first local input and output line pair, and, when being enabled, may amplify a voltage of the first local input and output line pair. The first local switch LSW1 may connect a first local input and output line pair and a global input and output line pair according to a control signal between the first local input and output line pair and the global input and output line pair.

The pre-charger PRE may be connected to a global input and output line pair, and may pre-charge the global input and output line pair at a pre-charge voltage according to a control signal. The write driver WD may be connected to a global input and output line pair, and may apply a voltage and/or a current corresponding to written data to the global input and output line pair during a write operation. Herein, the pre-charger PRE and the write driver WD may be respectively referred to as a pre-charge circuit and a write driving circuit. The global switch GSW may connect a global input and output line pair and an input and output line pair according to a control signal between the global input and output line pair and the input and output line pair. The input and output sense amplifier IOSA may be connected to an input and output line pair, and, when being enabled, may amplify a voltage of the input and output line pair. In some example embodiments, the memory device 30 may further include additional pre-chargers. For example, the memory device 30 may further include a pre-charger connected to a bit line pair and/or a pre-charger connected to a local input and output line pair.

As illustrated in FIG. 3, a global input and output line pair may be connected to the first local switch LSW1 to the nth local switch LSWn, and a global input and output line pair may have a length greater than that of a local input and output line pair. Accordingly, a global input and output line pair may have a parasitic capacitance greater than that of a local input and output line pair, and, when being operated at an identical voltage, may require a current greater than a current required by the local input and output line pair. As described above with reference to the drawings, a global input and output line pair may be pre-charged at a pre-charge voltage by the pre-charger PRE, and the pre-charge voltage may be between a negative supply voltage and a positive supply voltage (provided to a sense amplifier, for example). A global input and output line pair may be controlled to have a small swing voltage, and accordingly, a current consumed by a global input and output line pair may be reduced.

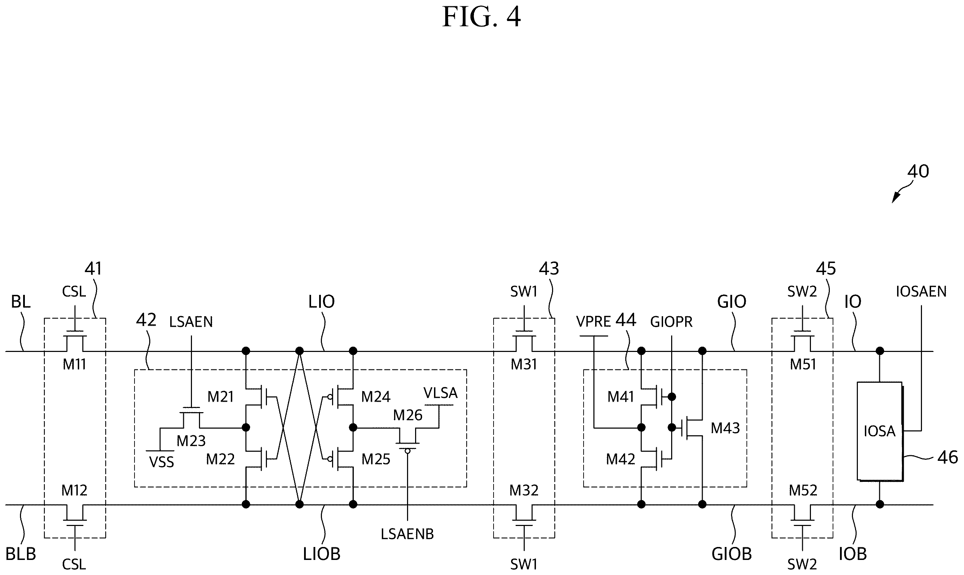

FIG. 4 is a circuit diagram illustrating a memory device 40 according to example embodiments of the present disclosure. For example, the circuit diagram of FIG. 4 illustrates examples of elements corresponding to one bit line pair and one local input and output line pair in the memory device 30 in FIG. 3. Hereinafter, duplicate descriptions among descriptions for FIG. 4 to descriptions for FIG. 3 will be omitted.

Referring to FIG. 4, the memory device 40 may include a bit line switch 41, a local sense amplifier 42, a local switch 43, a pre-charger 44, a global switch 45 and an input and output sense amplifier 46. The bit line switch 41 may be connected between a bit line pair and an input and output line pair, and may include a first transistor M11 and a second transistor M12 which are n-channel field effect transistors (NFETs). The first transistor M11 and the second transistor M12 may receive a column selection signal CSL, and may respectively connect the bit line BL and a complementary bit line BLB to a local input and output line LIO and a complementary local input and output line LIOB in response to the activated (in other words, high-leveled) column selection signal CSL.

A local sense amplifier 42 may be connected to a local input and output line pair, in other words, the local input and output line LIO and the complementary local input and output line LIOB, and may include a first transistor M21 through a third transistor M23 which are NFETs, and a fourth transistor M24 through a sixth transistor M26 which are p-channel field effect transistors (PFETs). The first transistor M21, a second transistor M22, the fourth transistor M24 and a fifth transistor M25 may correspond to two inverters which are cross-coupled between the local input and output line LIO and the complementary local input and output line LIOB. Further, the third transistor M23 may be connected between two inverters and a node to which the negative supply voltage VSS is applied, and the sixth transistor M26 may be connected between two inverters and a node to which a positive supply voltage VLSA is applied. As illustrated in FIG. 4, the local sense amplifier 42, in other words, two inverters, may be enabled in response to an activated (in other words, high-leveled) local sense amplifier enable signal LSAEN and an activated (in other words, low-leveled) complementary local sense amplifier enable signal LSAENB. The enabled local sense amplifier 42 may amplify a voltage of a local input and output line pair by using power provided by the negative supply voltage VSS and the positive supply voltage VLSA.

The local switch 43 may be connected between a local input and output line pair and a global input and output line pair, and may include a first transistor M31 and a second transistor M32 which are NFETs. The first transistor M31 and the second transistor M32 may receive a first control signal SW1, and may respectively connect the local input and output line LIO and the complementary local input and output line LIOB to the global input and output line GIO and the complementary global input and output line GIOB in response to the activated (in other words, high-leveled) first control signal SW1.

The pre-charger 44 may be connected to a global input and output line pair, in other words, the global input and output line GIO and the complementary global input and output line GIOB, and may include a first transistor M41 through a third transistor M43 which are NFETs. The first transistor M41 and a second transistor M42 may be connected in series with one another between the global input and output line GIO and the complementary global input and output line GIOB, and may receive a pre-charge voltage VPRE. Accordingly, the first transistor M41 and the second transistor M42 may pre-charge the global input and output line GIO and the complementary global input and output line GIOB in response to an activated (in other words, high-leveled) pre-charge signal GIOPR at the pre-charge voltage VPRE. The third transistor M43 may be connected between the global input and output line GIO and the complementary global input and output line GIOB, and may cause a potential of the global input and output line GIO and a potential of the complementary global input and output line GIOB to be identical in response to the activated (in other words, high-leveled) pre-charge signal GIOPR.

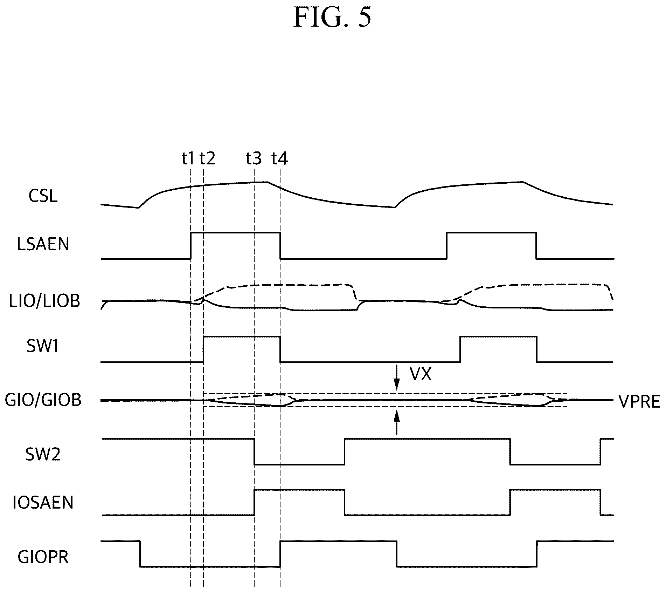

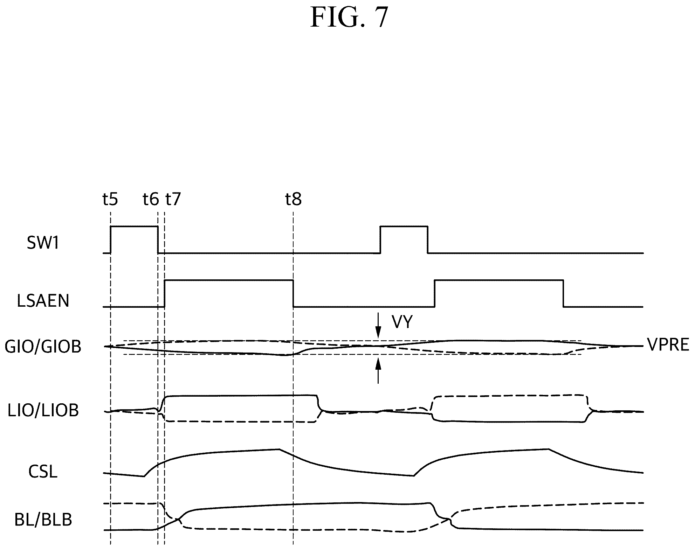

In some example embodiments, the pre-charge voltage VPRE may be a voltage among supply voltages. For example, the pre-charge voltage VPRE may be a voltage between the negative supply voltage VSS and the positive supply voltage VLSA provided to the local sense amplifier 42, and may be approximately an intermediate voltage between the positive supply voltage VLSA and the negative supply voltage VSS. If the pre-charge voltage VPRE is approximately a supply voltage and a voltage of one of the global input and output line GIO and the complementary global input and output line GIOB is pulled up or pulled down from the supply voltage in a read operation or a write operation, a charge may be focused on one between the global input and output line GIO and the complementary global input and output line GIOB for pre-charge. Nevertheless, as described hereinafter with reference to FIG. 5 and FIG. 7, in a case of being pre-charged at the pre-charge voltage VPRE which is an intermediate voltage, a voltage of the global input and output line GIO and a voltage of the complementary global input and output line GIOB during a read operation or a write operation may be away from the pre-charge voltage VPRE in opposite directions from one another, and a charge may be re-used while the voltage of the global input and output line GIO and the voltage of the complementary global input and output line GIOB return to the pre-charge voltage VPRE for pre-charge afterwards. As a result, current consumption may be reduced in a read operation or a write operation, and power consumption of the memory device 40 may be reduced.

The global switch 45 may be connected between a global input and output line pair and an input and output line pair, and may include a first transistor M51 and a second transistor M52 which are NFETs. The first transistor M51 and the second transistor M52 may receive a second control signal SW2, and may respectively connect the global input and output line GIO and the complementary global input and output line GIOB to the input and output line IO and the complementary input and output line IOB in response to the activated (in other words, high-leveled) second control signal SW2.

The input and output sense amplifier 46 may be connected to an input and output line pair, in other words, the input and output line IO and the complementary input and output line IOB. A voltage of an input and output line pair may be amplified in response to an activated input and output sense amplifier enable signal IOSAEN.

FIG. 5 is a timing chart illustrating an operation of a memory device according to example embodiments of the present disclosure. For example, the timing chart of FIG. 5 illustrates an example of a read operation performed in the memory device 40 of FIG. 4. Hereinafter, FIG. 5 will be described with reference to FIG. 4.

Referring to FIG. 5, the column selection signal CSL may be activated before time t1. Accordingly, a voltage of a bit line pair, which is changed according to a voltage of a memory cell, may be delivered to a local input and output line pair. In the time t1, the local sense amplifier enable signal LSAEN may be activated. The local sense amplifier 42 may be enabled, and amplification of a voltage of a local input and output line pair may be initiated by the local sense amplifier 42. The input and output sense amplifier 46 may amplify a voltage of an input and output line pair to output to the input and output line pair. Accordingly, as illustrated in FIG. 5, voltages of the local input and output line LIO and the complementary local input and output line LIOB may increase or decrease.

In time t2, the first control signal SW1 may be activated. The first control signal SW1 may be activated in order for the amplified voltage of the input and output line pair to be delivered to a global input and output line pair. For example, in order for the amplified voltage of the input and output line pair to be delivered to a global input and output line pair, the local switch 43 may connect the local input and output line pair and the global input and output line pair in response to the activated first control signal SW1. Accordingly, as illustrated in FIG. 5, voltages of the global input and output line GIO and the complementary global input and output line GIOB may increase or decrease. Due to the activated second control signal SW2, a voltage of the global input and output line pair may be delivered to the input and output line pair by the global switch 45.

In time t3, the second control signal SW2 may be deactivated, and the input and output sense amplifier enable signal IOSAEN may be activated. Accordingly, the input and output line pair may be disconnected from the global input and output line pair. In the time t3, the voltage of the input and output line pair delivered from the global input and output line pair, in other words, a voltage between the input and output line GIO and the complementary input and output line GIOB, may have a size sufficient to be amplified by the input and output sense amplifier 46. As a result, after the local sense amplifier 42 is enabled, the input and output sense amplifier 46 may be enabled, and the global switch 45 may disconnect the global input and output line pair from the input and output line pair.

In time t4, the pre-charge signal GIOPR may be activated. Accordingly, the global input and output line pair may be pre-charged at the pre-charge voltage VPRE. As illustrated in FIG. 5, after the voltage of the local input and output line pair is delivered to the global input and output line pair in the time t2, until the global input and output line pair is pre-charged in the time t4, the global input and output line pair may have a swing voltage VX. The time t3 may be determined in order for the voltage of the input and output line pair to have a size sufficient to be amplified by the input and output sense amplifier 46, and, as a result, a size of the swing voltage VX may be determined. Due to the pre-charge voltage VPRE which is an intermediate voltage, the swing voltage VX may be smaller than the voltage of the global input and output line pair in a case in which only one line of the global input and output line pair is pulled up or pulled down. Further, a charge of the complementary global input and output line GIOB may be used for pre-charge of the global input and output line GIO in the time t4, and, accordingly, a current and power consumed for the pre-charge thereof may be reduced. As described above with reference to FIG. 3, the global input and output line pair may have a relatively high parasitic capacitance, and, accordingly, the small swing voltage VX and re-use of a charge may significantly reduce the power consumption of a memory device.

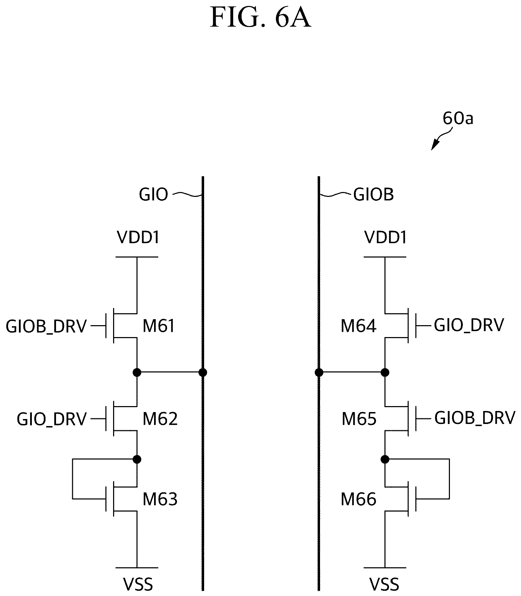

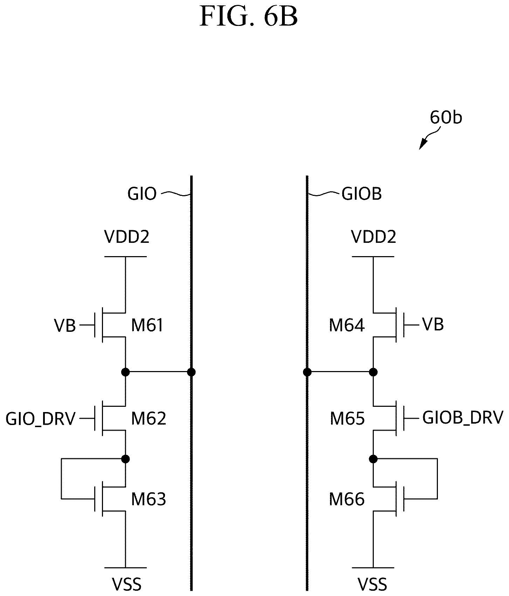

FIG. 6A and FIG. 6B are circuit diagrams illustrating examples of the write driver WD according to example embodiments of the present disclosure. As described above with reference to FIG. 3, the write driver WD may be connected to the global input and output line pair, and may apply a voltage corresponding to written data to the global input and output line pair in a write operation. The pre-charge voltage VPRE of the global input and output line pair may be an intermediate voltage as described above with reference to the drawings, and the write driver WD may operate the global input and output line pair in order for the voltage of the global input and output line pair to have a small swing voltage around the pre-charge voltage VPRE in a write operation.

Referring to FIG. 6A, a write driver 60a may include a first transistor M61 through a sixth transistor M66 which are NFETs. The first transistor M61 through a third transistor M63 may be connected in series between a first positive supply voltage VDD1 and the negative supply voltage VSS. The first transistor M61 and a second transistor M62 may be connected to the global input and output line GIO, and may respectively receive a complementary global input and output line driving signal GIOB_DRV and a global input and output line driving signal GIO_DRV. A gate and a drain of the third transistor M63 may be connected with one another, and, accordingly, the third transistor M63 may function as a diode.

A fourth transistor M64 through the sixth transistor M66 may be connected in series between the first positive supply voltage VDD1 and the negative supply voltage VSS. The fourth transistor M64 and a fifth transistor M65 may be connected to the complementary global input and output line GIOB, and may respectively receive the global input and output line driving signal GIO_DRV and the complementary global input and output line driving signal GIOB_DRV. A gate and a drain of the sixth transistor M66 may be connected with one another, and, accordingly, the sixth transistor M66 may function as a diode.

The first positive supply voltage VDD1 applied to the first transistor M61 and the fourth transistor M64 may be lower than the positive supply voltage VLSA provided to a sense amplifier, for example, the local sense amplifier 42 of FIG. 4. Further, a voltage applied to the second transistor M62 and the fifth transistor M65 may be higher by a forward voltage of a diode than the negative supply voltage VSS. Accordingly, a pull-up voltage and a pull-down voltage of the global input and output line GIO and the complementary global input and output line GIOB in a write operation may be limited, and, as described hereinafter with reference to FIG. 7, the global input and output line pair may have a small swing voltage from the pre-charge voltage VPRE in a write operation.

Referring to FIG. 6B, a write driver 60b may include the first transistor M61 through the sixth transistor M66 which are NFETs. The first transistor M61 through the third transistor M63 may be connected in series between a second positive supply voltage VDD2 and the negative supply voltage VSS. The first transistor M61 and the second transistor M62 may be connected to the global input and output line GIO, and may respectively receive a bias voltage VB and the global input and output line driving signal GIO_DRV. A gate and a drain of the third transistor M63 may be connected with one another, and, accordingly, the third transistor M63 may function as a diode.

The fourth transistor M64 through the sixth transistor M66 may be connected in series between the second positive supply voltage VDD2 and the negative supply voltage VSS. The fourth transistor M64 and the fifth transistor M65 may be connected to the complementary global input and output line GIOB, and may respectively receive the bias voltage VB and the complementary global input and output line driving signal GIOB_DRV. A gate and a drain of the sixth transistor M66 may be connected with one another, and, accordingly, the sixth transistor M66 may function as a diode.

The bias voltage VB applied to the first transistor M61 and the fourth transistor M64 may be lower than the positive supply voltage VLSA provided to a sense amplifier, for example, the local sense amplifier 42 of FIG. 4. Accordingly, a voltage of the global input and output line GIO and the complementary global input and output line GIOB may be limited to be equal to or smaller than the bias voltage VB. Further, a voltage applied to the second transistor M62 and the fifth transistor M65 may be higher by a forward voltage of a diode than the negative supply voltage VSS. Accordingly, a pull-up voltage and a pull-down voltage of the global input and output line GIO and the complementary global input and output line GIOB in a write operation may be limited, and, as described hereinafter with reference to FIG. 7, the global input and output line pair may have a small swing voltage from the pre-charge voltage VPRE in a write operation.

FIG. 7 is a timing chart illustrating an operation of a memory device according to example embodiments of the present disclosure. For example, the timing chart of FIG. 7 illustrates an example of a write operation performed in the memory device 40 of FIG. 4. Hereinafter, FIG. 7 will be described with reference to FIG. 4.

Referring to FIG. 7, in time t5, the first control signal SW1 may be activated. The local switch 43 may connect the local input and output line pair to the global input and output line pair in response to the activated first control signal SW1. Further, the write driver WD may apply a voltage corresponding to written data to the global input and output line pair. Accordingly, as illustrated in FIG. 7, the voltage of the global input and output line pair may be gradually away from the pre-charge voltage VPRE. Further, a voltage of the local input and output line pair may also change according to the voltage of the global input and output line pair.

In time t6, the first control signal SW1 may be deactivated. Accordingly, the local switch 43 may disconnect the local input and output line pair from the global input and output line pair in response to the deactivated first control signal SW1.

In time t7, the local sense amplifier enable signal LSAEN may be activated. The enabled local sense amplifier 42 may amplify the voltage of the local input and output line pair, and, accordingly, the voltage of the local input and output line pair may be amplified as illustrated in FIG. 7. As a voltage of the column selection signal CSL increases after the time t7, the bit line switch 41 may connect the bit line pair and the local input and output line pair, and, accordingly, the amplified voltage of the local input and output line pair may be applied to the bit line pair, and the voltage of the bit line pair may be amplified by a bit line sense amplifier (for example, BLSA1 in FIG. 3).

As illustrated above with reference to the drawings, the pre-charge voltage VPRE may be an intermediate voltage, and a swing voltage VY of the global input and output line pair may be smaller than the voltage of the global input and output line pair in a case in which only one line of the global input and output line pair is pulled up or pulled down. Further, as illustrated above with reference to FIG. 6A and FIG. 6B, the write driver WD may limit the pull-up voltage and the pull-down voltage of the global input and output line pair in a write operation. Accordingly, as illustrated in FIG. 7, the global input and output line pair may have the small swing voltage VY. A charge of the complementary global input and output line GIOB may be used for the pre-charge of the global input and output line GIO, and, accordingly, a current and power consumed for the pre-charge thereof may be reduced.

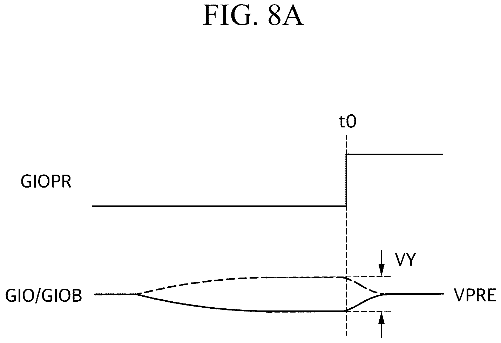

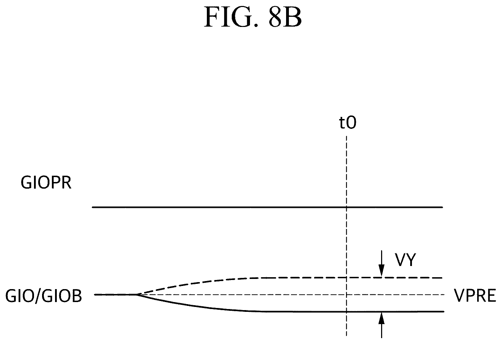

FIG. 8A and FIG. 8B are timing charts illustrating examples of an operation of a memory device according to example embodiments of the present disclosure. For example, the timing charts in FIG. 8A and FIG. 8B illustrate examples of a write operation performed in a memory device. As described above with reference to FIG. 7, the global input and output line pair may have the swing voltage VY in a write operation. In some example embodiments, the write operation of FIG. 8A and FIG. 8B may be performed by the memory device 40 of FIG. 4. Hereinafter, FIG. 8A and FIG. 8B will be described with reference to FIG. 4.

In some example embodiments, the memory device 40 may selectively pre-charge the global input and output line pair before writing next data after writing data. For example, as illustrated in FIG. 8A and FIG. 8B, the global input and output line pair may have the swing voltage VY by the write driver WD. As illustrated in FIG. 8A, due to the pre-charge signal GIOPR activated in time t0, the global input and output line pair may be pre-charged at the pre-charge voltage VPRE. Meanwhile, as illustrated in FIG. 8B, due to the pre-charge signal GIOPR which is maintained in a deactivated state in the time t0, the global input and output line pair may maintain the swing voltage VY.

In some example embodiments, the memory device 40 may support burst write. The memory device 40, in case that a toggle ratio of written data is high, may pre-charge the global input and output line pair at the pre-charge voltage VPRE as illustrated in FIG. 8A, whereas, in case that the toggle ratio of the written data is low, may skip pre-charge of the global input and output line pair as illustrated in FIG. 8B. Accordingly, power consumption caused by unnecessary pre-charge in the memory device 40 may be reduced. In some example embodiments, a memory controller (or host) may set a value of a mode register of the memory device 40 based on the toggle ratio of the written data. The memory device 40 may identify a mode according to the value of the mode register, and may perform an operation of FIG. 8A in a first mode, while being able to perform an operation of FIG. 8B in a second mode. In some example embodiments, the memory device 40 may compare first written data and following second written data in the burst write, and, in case that the second written data is different from the first written data, may perform an operation of FIG. 8A, while being able to perform an operation of FIG. 8B in case that the second written data is identical to the first written data.

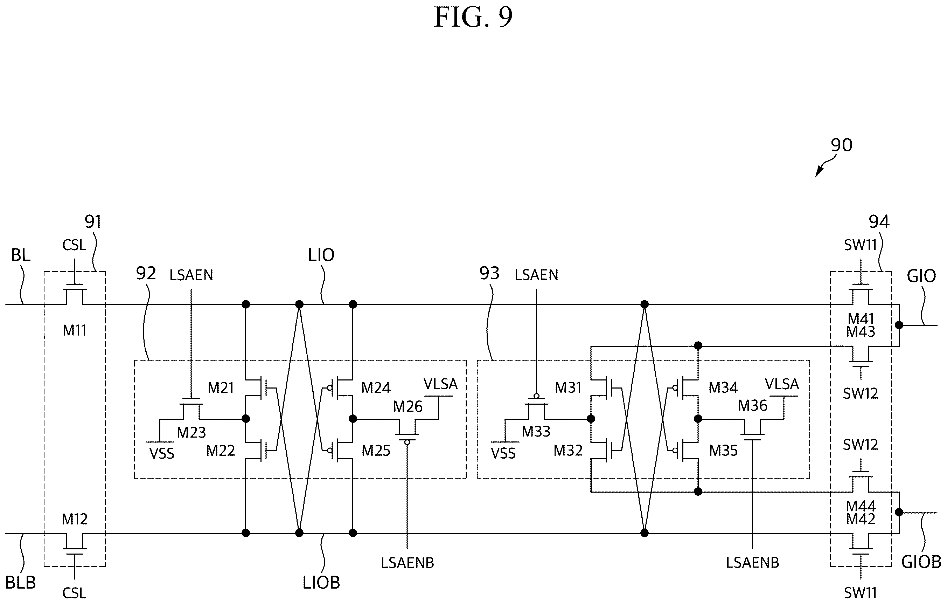

FIG. 9 is a circuit diagram illustrating a memory device 90 according to example embodiments of the present disclosure. For example, the circuit diagram of FIG. 9 illustrates examples of elements corresponding to one bit line pair and one local input and output line pair in the memory device 30 in FIG. 3. Hereinafter, duplicate descriptions among descriptions for FIG. 9 to descriptions for FIG. 4 will be omitted.

Referring to FIG. 9, the memory device 90 may include a bit line switch 91, a first local sense amplifier 92, a second local sense amplifier 93 and a local switch 94. The bit line switch 91 may include the first transistor M11 and the second transistor M12 which receive the column selection signal CSL. The local switch 94 may include the first transistor M41 and the second transistor M42 receiving a first control signal SW11, and include the third transistor M43 and a fourth transistor M44 receiving a first control signal SW12.

In some example embodiments, a local sense amplifier may have a cascade structure. For example, as illustrated in FIG. 9, the first local sense amplifier 92 may respond to two inverters which are cross-coupled at a local input and output line pair, and the second local sense amplifier 93 may respond to two inverters of which input is connected to the local input and output line pair. In a read operation, the first control signal SW11 may be deactivated, and the first control signal SW12 may be activated. Accordingly, a voltage of the local input and output line pair may be amplified by the first local sense amplifier 92 and the second local sense amplifier 93, and read speed may be improved. In a write operation, the first control signal SW11 may be activated, the first control signal SW12 may be deactivated, and the second local sense amplifier 93 may not be used.

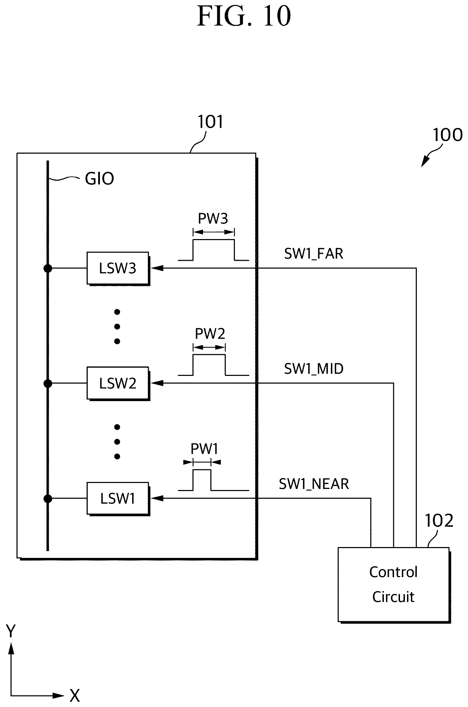

FIG. 10 is a block diagram illustrating a memory device 100 according to example embodiments of the present disclosure. As illustrated in FIG. 10, the memory device 100 may include a cell array 101 and a control circuit 102. The global input and output line GIO may extend from the cell array 101 in a Y-axis direction, and a plurality of local switches connected to the global input and output line GIO, such as the first local switch LSW1 through a third local switch LSW3, may be arranged in the Y-axis direction. As shown in FIG. 10, the first local switch LSW1 is closer to the control circuit 102 than the second local switch LSW2 and the third local switch LSW3, and the third local switch LSW3 is further from the control circuit 102 than the first local switch LSW1 and the second local switch LSW2.

In some example embodiments, the control circuit 102 may generate a control signal provided to a switch to vary depending on a distance from the control circuit 102. For example, as illustrated in FIG. 10, a first control signal SW1_NEAR provided to the first local switch LSW1 adjacent to the control circuit 102 may have a first activation pulse width PW1, and a first control signal SW1_FAR provided to the third local switch LSW3 spaced far apart from the control circuit 102 may have a third activation pulse width PW3, and a first control signal SW1_MID provided at a second local switch LSW2 between the first local switch LSW1 and the third local switch LSW3 may have a second activation pulse width PW2. As illustrated in FIG. 10, the second activation pulse width PW2 may be greater than the first activation pulse width PW1 and smaller than the third activation pulse width PW3 (PW1<PW2<PW3).

Time required for a first control signal generated by the control circuit 102 to reach the third local switch LSW3 may be longer than time required for the same to reach the first local switch LSW1. Further, parasitic resistance and/or parasitic capacitance of a path through which the first control signal SW1_FAR provided to the third local switch LSW3 is moved may be relatively high. Therefore, the control circuit 102 may generate the first control signal SW1_FAR having a sufficient pulse width, in other words, the third activation pulse width PW3 to provide the same to a third switch circuit LSW3. Nevertheless, in case that the first control signal SW1_NEAR provided to the first local switch LSW1 has the third activation pulse width PW3 in the same manner as the first control signal SW1_FAR, the local input and output line pair may be connected to the global input and output line pair for time equal to or more than time required for writing or reading, while consuming unnecessary power. Therefore, as illustrated in FIG. 10, the first control signal SW1_NEAR may have a shortened activation pulse width, in other words, the first activation pulse width PW1, and accordingly, power consumption of the memory device 100 may be reduced during a read operation and a write operation.

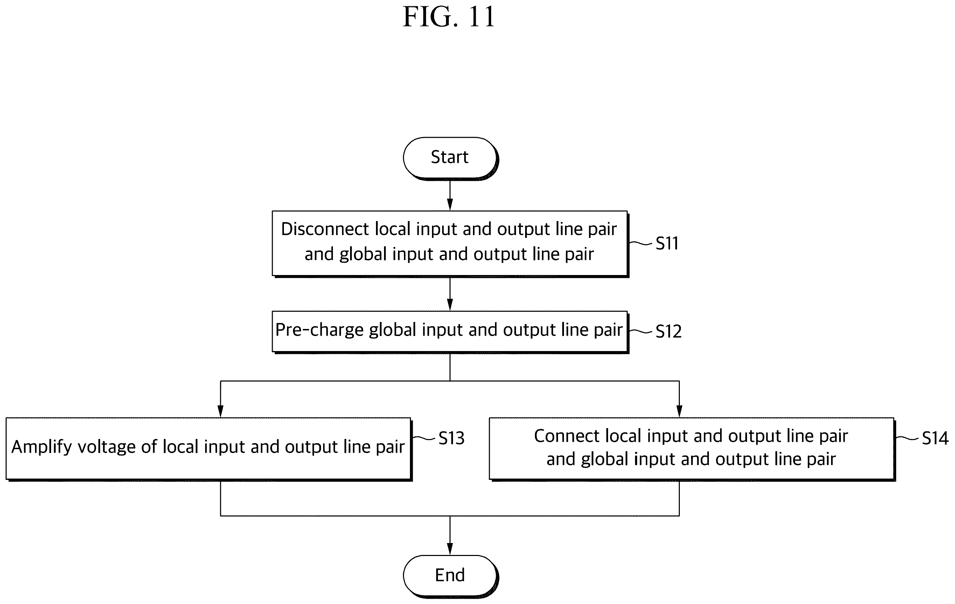

FIG. 11 is a flowchart illustrating an operation method of a memory device according to example embodiments of the present disclosure. For example, the flowchart of FIG. 11 illustrates a read operation performed by a memory device. As illustrated in FIG. 11, the operation method of the memory device may include a plurality of operations (e.g., operation S11 to operation S14). In some example embodiments, the method of FIG. 11 may be performed by the memory device 40 of FIG. 4. Hereinafter, FIG. 11 will be described with reference to FIG. 4.

Referring to FIG. 11, in operation S11, the local input and output line pair and the global input and output line pair may be disconnected. For example, the local switch 43 may disconnect the local input and output line pair and the global input and output line pair in response to the deactivated first control signal SW1.

In operation S12, the global input and output line pair may be pre-charged. For example, the pre-charger 44 may pre-charge the global input and output line pair at the pre-charge voltage VPRE in response to the activated pre-charge signal GIOPR. As described above with reference to the drawings, the pre-charge voltage VPRE may be an intermediate voltage, and the global input and output line pair may have a small swing voltage around the pre-charge voltage VPRE. In some example embodiments, operation S12 may be performed after operation S11 is performed. In some example embodiments, operation S12 may be finished before operation S13 described hereinafter is initiated.

In operation S13, the voltage of the local input and output line pair may be amplified, and, in operation S14, the local input and output line pair and the global input and output line pair may be connected. In some example embodiments, in case that the local sense amplifier 42 is enabled, the local input and output line pair and the global input and output line pair may be connected. For example, the local sense amplifier 42 may be enabled in response to the activated local sense amplifier enable signal LSAEN, and the local switch 43 may connect the local input and output line pair and the global input and output line pair in response to the activated first control signal SW1. Accordingly, the voltage of the local input and output line pair, which is amplified by the local sense amplifier 42, may be delivered to the pre-charged global input and output line pair.

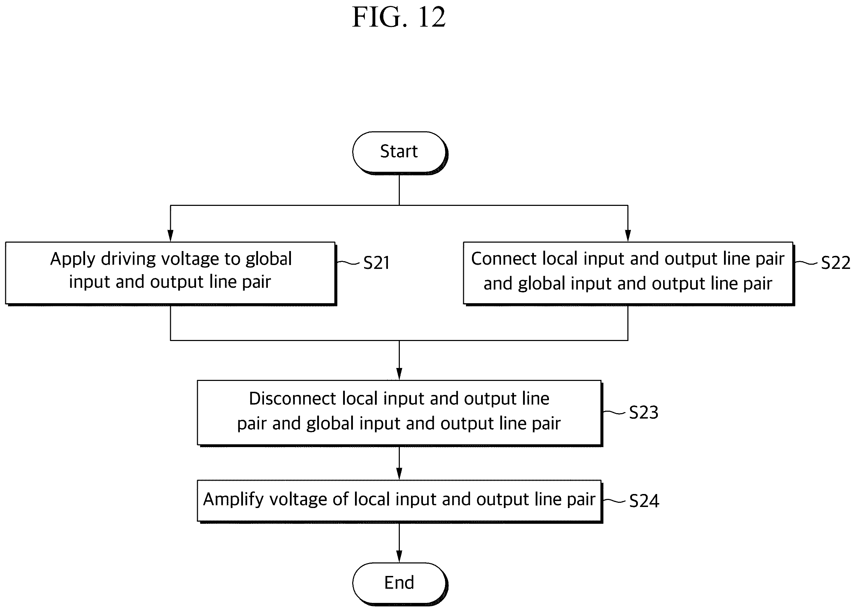

FIG. 12 is a flowchart illustrating an operation method of a memory device according to example embodiments of the present disclosure. For example, the flowchart of FIG. 12 illustrates a write operation performed by a memory device. As illustrated in FIG. 12, the operation method of the memory device may include a plurality of operations (e.g., operation S21 to operation S24). In some example embodiments, the method of FIG. 12 may be performed by the memory device of FIG. 4. Hereinafter, FIG. 12 will be described with reference to FIG. 4.

Referring to FIG. 12, in operation S21, a driving voltage may be applied to the global input and output line pair, and, in operation S22, the local input and output line pair and the global input and output line pair may be connected. For instance, the write driver WD may apply a voltage corresponding to written data to the global input and output line pair. Further, the local switch 43 may connect the local input and output line pair and the global input and output line pair in response to the activated first control signal SW1. Therefore, the voltage applied to the global input and output line pair may be delivered to the local input and output line pair.

In operation S23, the local input and output line pair and the global input and output line pair may be disconnected. For example, the local switch 43 may disconnect the local input and output line pair and the global input and output line pair in response to the deactivated first control signal SW1.

In operation S24, the voltage of the local input and output line pair may be amplified. For instance, the local sense amplifier 42 may be enabled in response to the activated local sense amplifier enable signal LSAEN, and may amplify the voltage of the local input and output line pair.

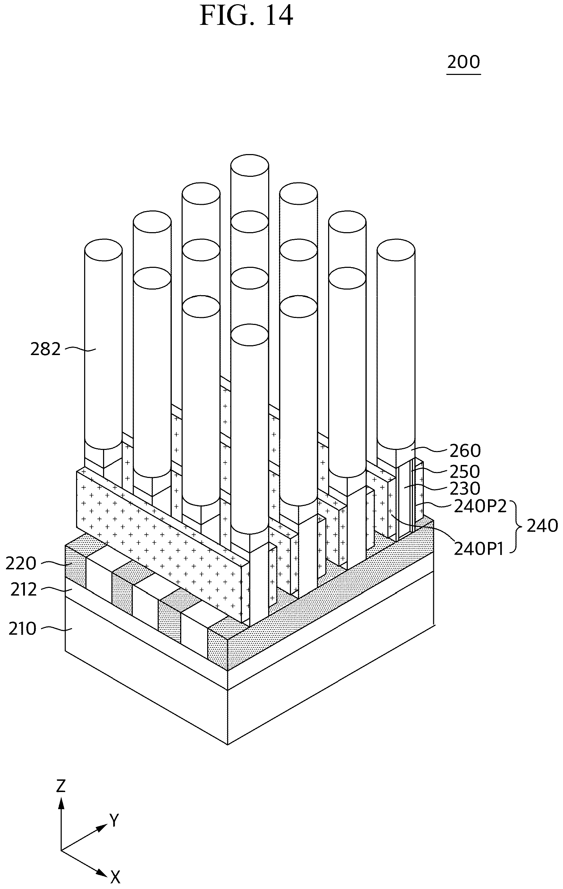

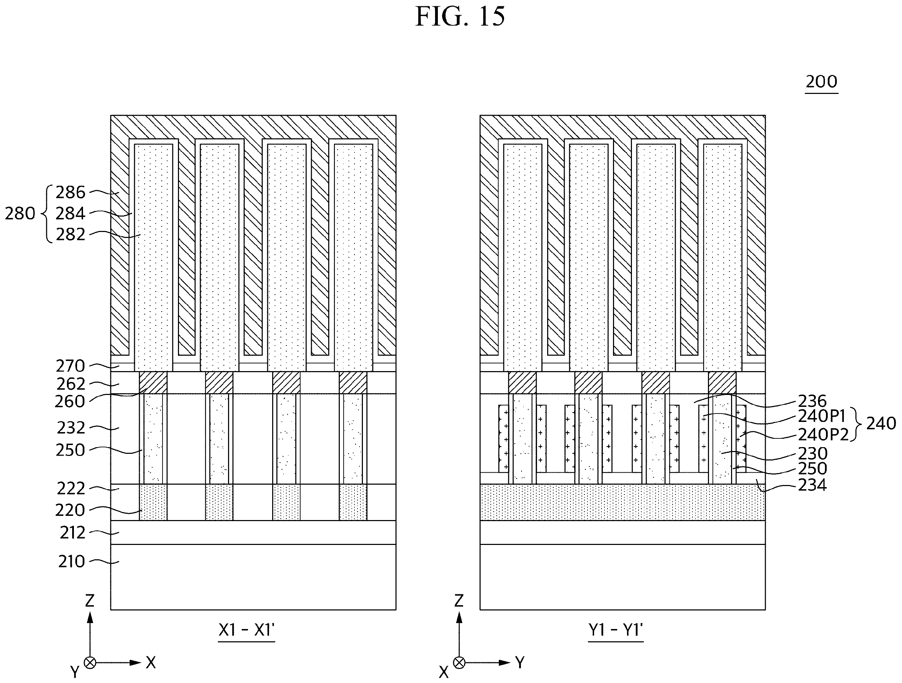

FIG. 13 is a drawing illustrating a layout of an integrated circuit device 200 according to example embodiments of the present disclosure, and FIG. 14 is a perspective view illustrating the integrated circuit device 200 according to example embodiments of the present disclosure, and FIG. 15 is a cross-sectional view cutting the integrated circuit device 200 along an X1-X1' line and a Y1-Y1' line of FIG. 13 according to example embodiments of the present disclosure.

Referring to FIG. 13 to FIG. 15, the integrated circuit device 200 may include a substrate 210, a plurality of first conductive lines 220, a channel layer 230, a gate electrode 240, a gate insulation layer 250 and a capacitor structure 280. The integrated circuit device 200 may be a memory device including a vertical channel transistor (VCT). The VCT may refer to a structure in which a channel length of the channel layer 230 extends from the substrate 210 in a vertical direction.

A lower insulation layer 212 may be arranged on the substrate 210, and the plurality of first conductive lines 220 may be spaced apart from one another in a first direction (an X-axis direction) and may extend in a second direction (a Y-axis direction) on the lower insulation layer 212. On the lower insulation layer 212, a plurality of first insulation patterns 222 may be arranged to fill a space between the plurality of first conductive lines 220. The plurality of first insulation patterns 222 may extend in the second direction (the Y-axis direction), and an upper surface of the plurality of first insulation patterns 222 may be arranged on an identical level to an upper surface of the plurality of first conductive lines 220. The plurality of first conductive lines 220 may function as a bit line of the integrated circuit device 200.

In some example embodiments, the plurality of first conductive lines 220 may include doped polysilicon, metal, conductive metal nitride, conductive metal silicide, conductive metal oxide, or a combination thereof. The plurality of first conductive lines 220 may include a single layer or multiple layers of the above-described materials. In example embodiments, the plurality of first conductive lines 220 may include a two-dimensional semiconductor material, and, for instance, the two-dimensional semiconductor material may include graphene, carbon nanotube, or a combination thereof.

The channel layer 230 may be arranged in a matrix shape which is arranged by being spaced apart in the first direction (the X-axis direction) and the second direction (the Y-axis direction) on the plurality of first conductive lines 220. The channel layer 230 may have a first width in the first direction (the X-axis direction) and a first height in a third direction (a Z-axis direction), and the first height may be greater than the first width. For instance, the first height may be approximately two times to ten times of the first width, without being limited thereto. A bottom portion of the channel layer 230 may function as a first source/drain area (not illustrated), and an upper portion of the channel layer 230 may function as a second source/drain area (not illustrated), and a portion of the channel layer 230 between the first and second source/drain areas may function as a channel area (not illustrated).

In some example embodiments, the channel layer 230 may include an oxide semiconductor. The channel layer 230 may include a single layer or multiple layers of an oxide semiconductor. In some example embodiments, the channel layer 230 may have a bandgap energy which is greater than a bandgap energy of silicon. The channel layer 230 may be polycrystal or amorphous but the same is not limited thereto. In some example embodiments, the channel layer 230 may include a two-dimensional semiconductor material, and, for instance, the two-dimensional semiconductor material may include graphene, carbon nanotube, or a combination thereof.

The gate electrode 240 may extend in the first direction (the X-axis direction) on both side walls of the channel layer 230. The gate electrode 240 may include a first sub-gate electrode 240P1 facing a first side wall of the channel layer 230, and a second sub-gate electrode 240P2 facing a second side wall opposite to the first side wall of the channel layer 230. As the single channel layer 230 is arranged between the first sub-gate electrode 240P1 and the second sub-gate electrode 240P2, the integrated circuit device 200 may have a dual gate transistor structure. Nevertheless, example embodiments are not limited thereto, and a single gate transistor structure may be implemented with the second sub-gate electrode 240P2 being omitted and only the first sub-gate electrode 240P1 being formed at which the channel layer 230 faces the first side wall. The gate electrode 240 may include doped polysilicon, metal, conductive metal nitride, conductive metal silicide, conductive metal oxide, or a combination thereof.

The gate insulation layer 250 may surround a side wall of the channel layer 230, and may be interposed between the channel layer 230 and the gate electrode 240. For instance, as illustrated in FIG. 13, an entire side wall of the channel layer 230 may be surrounded by the gate insulation layer 250, and a portion of a side wall of the gate electrode 240 may be in contact with the gate insulation layer 250. In example embodiments, the gate insulation layer 250 may extend in an extension direction of the gate electrode 240, in other words, in the first direction (the X-axis direction), and only two side walls facing the gate electrode 240 among side walls of the channel layer 230 may be in contact with the gate insulation layer 250. In some example embodiments, the gate insulation layer 250 may be constituted with a silicon oxide film, a silicon oxynitride film, a high-dielectric film with a higher dielectric constant than a silicon oxide film, or a combination thereof. The high-dielectric film may be constituted with a metallic oxide or a metallic oxynitride.

On the plurality of first insulation patterns 222, a plurality of second insulation patterns 232 may extend in the second direction (the Y-axis direction), and the channel layer 230 may be arranged between adjacent two second insulation patterns among the plurality of second insulation patterns 232. Further, between the adjacent two second insulation patterns, a first buried layer 234 and a second buried layer 236 may be arranged in a space between adjacent two channel layers. The first buried layer 234 may be arranged at the bottom portion of the space between the adjacent two channel layers 230, and the second buried layer 236 may be formed to fill the remainder of the space between the adjacent two channel layers on the first buried layer 234. An upper surface of the second buried layer 236 may be arranged at an identical level to an upper surface of the channel layer 230, and the second buried layer 236 may cover an upper surface of the gate electrode 240. On the other hand, the plurality of second insulation patterns 232 may be constituted with a material layer continuous to the plurality of first insulation patterns 222 or the second buried layer 236 may be constituted with a material layer continuous to the first buried layer 234.

A capacitor contact 260 may be arranged on the channel layer 230. The capacitor contact 260 may be arranged to vertically overlap the channel layer 230, and may be arranged in a matrix shape which is arranged by being spaced apart in the first direction (the X-axis direction) and the second direction (the Y-axis direction). An upper insulation layer 262 may surround a side wall of the capacitor contact 260 on the plurality of second insulation patterns 232 and the second buried layer 236.

An etching stopping film 270 may be arranged on the upper insulation layer 262, and the capacitor structure 280 may be arranged on the etching stopping film 270. The capacitor structure 280 may include a lower electrode 282, a capacitor dielectric layer 284 and an upper electrode 286. The lower electrode 282 may penetrate the etching stopping film 270 to be electrically connected to an upper surface of the capacitor contact 260. The lower electrode 282 may be formed as a pillar type extending in the third direction (the Z-axis direction), without being limited thereto. In some example embodiments, the lower electrode 282 may be arranged to vertically overlap the capacitor contact 260, and may be arranged in a matrix shape which is arranged by being spaced apart in the first direction (the X-axis direction) and the second direction (the Y-axis direction). On the other hand, a landing pad (not illustrated) may be further arranged between the capacitor contact 260 and the lower electrode 282, in order for the lower electrode 282 to be arranged in a hexagonal shape.

## Claims

1. A memory device comprising:
a first sense amplification circuit (42; 92, 93) configured to amplify a voltage of a first input and output line pair (LIO, LIOB);
a pre-charge circuit (44) connected to a second input and output line pair (GIO, GIOB); and
a first switch circuit (43; 94) between the first input and output line pair (LIO, LIOB) and the second input and output line pair (GIO, GIOB),
wherein the pre-charge circuit (44) is configured to pre-charge the second input and output line pair (GIO, GIOB) at a pre-charge voltage after the first switch circuit (43; 94) disconnects the first input and output line pair (LIO, LIOB) from the second input and output line pair (GIO, GIOB), and
wherein the first switch circuit (43; 94) is configured to connect the first input and output line pair (LIO, LIOB) to the second input and output line pair (GIO, GIOB) to deliver a voltage of the first input and output line pair (LIO, LIOB), which is amplified by the first sense amplification circuit (42; 92, 93), to the pre-charged second input and output line pair (GIO, GIOB) in a read operation.

2. The memory device of claim 1, further comprising:
a second sense amplification circuit (46); and
a second switch circuit (45) between the second input and output line pair (GIO, GIOB) and the second sense amplification circuit (46).

3. The memory device of claim 2, wherein the second sense amplification circuit (46) is configured to be enabled after the first sense amplification circuit (42; 92, 93) is enabled in the read operation.

4. The memory device of claim 2, wherein the second switch circuit (45) is configured to disconnect the second input and output line pair (GIO, GIOB) from the second sense amplification circuit (46) in response to a deactivated second control signal after the first sense amplification circuit (42; 92, 93) is enabled in the read operation.

5. The memory device of any one of claims 2 to 4, wherein the pre-charge circuit (44) is configured to pre-charge the second input and output line pair (GIO, GIOB) at the pre-charge voltage after the second switch circuit (45) disconnects the second input and output line pair (GIO, GIOB) from the second sense amplification circuit (46).

6. The memory device of claim 5, wherein the pre-charge voltage is a voltage between a first supply voltage and a second supply voltage provided to the first sense amplification circuit (42; 92, 93).

7. The memory device of any one of claims 1 to 6, further comprising:
a memory cell (MC) connected to a bit line pair (BL1, BLB1; ...; BLn, BLBn); and
a third switch circuit (BLSW1; ...; BLSWn) between the bit line pair (BL1, BLB1; ...,;BLn, BLBn) and the first input and output line pair (LIO1, LIOB1; ....; LIOn, LIOBn).

8. The memory device of any one of claims 1 to 7, further comprising:
a plurality of first switch circuits (LSW1 to LSW3) comprising the first switch circuit (43; 94); and
a control circuit (102) configured to respectively generate a plurality of first control signals in the plurality of first switch circuits (LSW1 to LSW3),
wherein a first control signal provided to one of the plurality of first switch circuits which is closer to the control circuit has an activation pulse width which is shorter than that of a first control signal provided to another one of the plurality of first switch circuits which is further from the control circuit (102) among the plurality of first switch circuits (LSW1 to LSW3).

9. The memory device of any one of claims 1 to 8, further comprising a write driving circuit (WD, 60b) connected to the second input and output line pair (GIO, GIOB),
wherein the write driving circuit (WD, 60b) is configured to be enabled in case that the first switch circuit (43; 94) connects the first input and output line pair (LIO, LIOB) to the second input and output line pair (GIO, GIOB) in a write operation.

10. The memory device of claim 9, wherein the first sense amplification circuit (42; 92, 93) is configured to be enabled after the second input and output line pair (GIO, GIOB) is disconnected from the first input and output line pair (LIO, LIOB) by the first switch circuit (43; 94) in the write operation.

11. The memory device of claim 9 or 10, wherein the write driving circuit (WD, 60b) comprises a first transistor (M61, M64) through a third transistor (M63, M66) which are connected in series with one another between a positive supply voltage node and a negative supply voltage node.

12. An operation method of a memory device, comprising:
disconnecting (S11), in a read operation, a first input and output line pair (LIO, LIOB) and a second input and output line pair (GIO, GIOB);
pre-charging (S12), in the read operation, the second input and output line pair (GIO, GIOB) at a pre-charge voltage;
amplifying (S13), in the read operation, a voltage of the first input and output line pair (LIO, LIOB); and
connecting (S14), in the read operation, in order for the amplified voltage of the first input and output line pair (LIO, LIOB) to be delivered to the pre-charged second input and output line pair (GIO, GIOB), the first input and output line pair (LIO, LIOB) and the second input and output line pair (GIO, GIOB).

13. The operation method of the memory device of claim 12, wherein the pre-charging (S12) of the second input and output line pair (GIO, GIOB) is performed after disconnecting (S11) the first input and output line pair (LIO, LIOB) and the second input and output line pair (GIO, GIOB) is performed.

14. The operation method of the memory device of claim 12 or 13, further comprising:
connecting (S22), in a write operation, the first input and output line pair (LIO, LIOB) and the second input and output line pair (GIO, GIOB); and
applying (S21), in the write operation, a driving voltage to the second input and output line pair (GIO, GIOB).

15. The operation method of the memory device of claim 14, further comprising:
disconnecting (S23), in the write operation, the first input and output line pair (LIO, LIOB) and the second input and output line pair (GIO, GIOB); and
amplifying (S24), in the write operation, the voltage of the first input and output line pair (LIO, LIOB).
